# EUROPEAN PATENT APPLICATION

(11) **EP 2 535 947 A1**
(43) Date of publication of application: **19.12.2012**
(21) Application number: 11742282.4
(22) Date of filing: 10.02.2011
(51) Int. Cl.: H01L 31/042

(54) **SOLAR CELL MODULE AND PRODUCTION METHOD FOR SOLAR CELL MODULE**

(30) Priority: 12.02.2010 JP 2010028570
(71) Applicant: Mitsubishi Chemical Corporation, Chiyoda-ku Tokyo 100-8251 (JP)
(72) Inventor: OOIZUMI, Junichi, Yokohama-shi Kanagawa 227-8502 (JP); FUNAYAMA, Katsuya, Yokkaichi-shi Mie 510-8530 (JP); KASHIWAGI, Takuya, Yokkaichi-shi Mie 510-8530 (JP); YONEYAMA, Takahiro, Yokkaichi-shi Mie 510-8530 (JP)
(74) Representative: HOFFMANN EITLE
(86) International application number: PCT/JP2011/052808
(87) International publication number: WO 2011/099539

(57) **Abstract**

A solar cell module having a metal layer as a substrate, and being usable pratically. The solar cell module 10 has such a configuration that a weather resistant layer 11, an encapsulation layer 12, a power generation element 13 including a power generation layer sandwiched between a couple of electrodes, a power generation element substrate, a fluorinated hydrocarbon resin layer 16, and a metal layer 17 stacked in this order.

## Description

### TECHNICAL FIELD

The present invention relates to a solar cell module, and a method of manufacturing a solar cell module.

### BACKGROUND ART

A solar cell (a solar cell module or a combination of two or more solar cell modules) is a clean power generation apparatus that does not emit carbon dioxide which contributes to global warming and harmful exhaust. Therefore, solar batteries have been installed at various spots (an outer wall of a building, an upper surface of a cargo space of a boxcar, a portable device, etc.).

### [Prior Art Reference]

Patent Document 1: Japanese Laid-Open Application 2002-151718

### SUMMARY OF THE INVENTION

### Problems to be Solved by the Invention

Adopting a metal layer as a substrate of a solar cell module makes it easier to use the solar cell module as an exterior wall finish (a placage) of a building, a component of a package of a portable device, etc. It also makes it easier to install the solar cell module at another member.

However, a practically usable solar cell module having a metal layer as a substrate has not been developed yet.

Such being the case, an object of the present invention is to provide a practically usable solar cell module having a metal layer as a substrate. Moreover, another object of the present invention is to provide a method of manufacturing a solar cell module by which such solar cell module can be manufactured.

### Means for solving the Problems

As a result of intensive research concerning a practically usable solar cell module that has a metal layer as a substrate, the present inventors discovered that a practically usable solar cell module with high durability can be actualized by adopting a fluorinated hydrocarbon resin layer (especially, a layer made of a resin selected from the group consisting of PFA, ETFE, PVDF, ECTFE and FEVE) as a layer for bonding a metal layer and a power generation element substrate (or a second encapsulation layer) of the solar cell module.

The solar cell module according to the present invention has been completed based on the above-mentioned knowledge. The solar cell module according to the present invention has such a configuration that a weather resistant layer, an encapsulation layer, a power generation element including a power generation layer sandwiched between a couple of electrodes, a power generation element substrate, a fluorinated hydrocarbon resin layer, and a metal layer stacked in this order.

Moreover, a method of manufacturing a solar cell module according to the present invention is characterized in that a solar cell module which includes a weather resistant layer, an encapsulation layer, a power generation element including a power generation layer sandwiched between a couple of electrodes, a power generation element substrate, a fluorinated hydrocarbon resin layer, and a metal layer stacked in this order is unified by thermal lamination.

It is preferred that the thickness of the encapsulation layer of the solar cell module of the present invention be 30 µm or more and 800 µm or less. The reason is that it is possible to prevent the power generation layer from being damaged without increasing the module weight and the manufacturing cost excessively by using the encapsulation layer having a thickness of 30 µm or more and 800 µm or less. The thickness of the power generation element layer is preferable thinner than the thickness of the encapsulation layer in order to prevent the encapsulation layer from being cracked when the solar cell module is bent.

On the occasion of actualizing (manufacturing) the solar cell module of the present invention, it is preferred that the weather resistant layer have a filtered maximum waviness, WCM, in conformity with JIS B0601 of not less than 18 µm and a mean spacing of local peaks, WC-Sm, of not more than 2.5 mm. The reason is that, when the weather resistant layer has such surface profile, it is feasible to manufacture the solar cell module without forming creases on the weather resistant layer, and to allow light reflected by the weather resistant layer (the solar cell module) to diffuse (to actualize the solar cell module which is not **dazziling** even if viewed from any angle), and to prevent the gloss of the metal layer (the part of the metal layer not covered with power generation element) from being lost.

Note that the solar cell module of which the weather resistant layer has the above-mentioned surface profile can be actualized using "the weather resistant layer having the above-mentioned surface profile originally." By adopting unifying step of further processing the surface of the weather resistant layer so as to have a filtered maximum waviness, WCM, in conformity with JIS B0601 of not less than 18 µm and a mean spacing of local peaks, WC-Sm, of not more than 2.5 mm, it is feasible to manufacture the solar cell module of which the weather resistant layer has the above-mentioned surface profile easily.

For actualizing the solar cell module of the present invention, it is possible to add a second encapsulation layer arranged between the power generation element and the fluorinated hydrocarbon resin layer. Moreover, the solar cell module of the present invention may be used for manufacturing the solar cell module solar including a second encapsulation layer arranged between the power generation element and the fluorinated hydrocarbon resin layer.

Uniting the components of the solar cell module by thermal lamination in the method of manufacturing a solar cell module of the present invention can be achieved by various techniques/steps having specific contents different from each other. However, with a step (process) of "unifying the metal layer on a surface of which the fluorinated hydrocarbon resin is formed, and other components of the solar cell module by thermal lamination" or "unifying the metal layer on a surface of which the fluorinated hydrocarbon resin is formed, the power generation element substrate on a surface of which the power generation element is formed, and other components of the solar cell module by thermal lamination," it is feasible to manufacture the solar cell module with especial ease.

### Effects of the Invention

According to the present invention, a practically usable solar cell module having a metal layer as a substrate, and a method of manufacturing a solar cell module capable of manufacturing such solar cell module can be provided.

### BRIEF DESCRIPTION OF DRAWINGS

FIG. 1 is a sectional view of a principal part of a solar cell module according to a first embodiment of the present invention;
FIG. 2 is a plan view of the solar cell module according to the 1st embodiment;
FIG. 3 is a sectional view of a edge portion of the solar cell module according to the 1st embodiment; and
FIG. 4 is a sectional view of a principal part of a solar cell module according to a second embodiment of the present invention.

### EMBODIMENTS OF THE INVENTION

Embodiments of the present invention will hereinafter be described in depth with reference to the drawings.

### «First Embodiment»

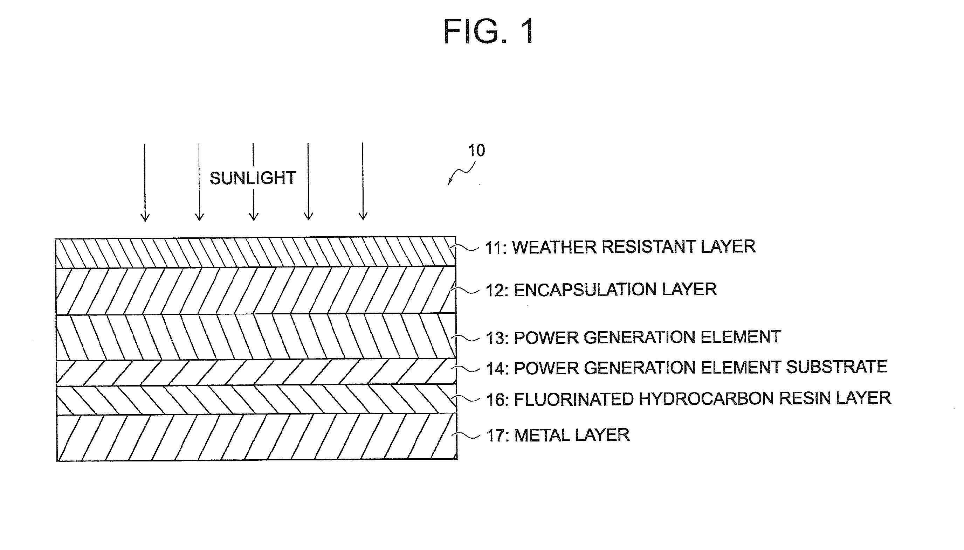

FIG. 1 is a sectional view of a principal part of a solar cell module according to a first embodiment of the present invention;

The solar cell module according to the first embodiment of the present invention, as illustrated, has such configuration (construction) that a weather resistant layer 11, an encapsulation layer 12, a power generation element 13, a power generation element substrate 14, a fluorinated hydrocarbon layer 16 and a metal layer 17 are stacked in this order.

### [Metal Layer 17]

The metal layer 17 is a material for supporting the other components of the solar cell module 10. It is possible to use, as the metal layer 17, plate shaped member consisting of aluminum, stainless steel, copper, titanium, nickel, iron, those alloy of such metals, etc. that is, a so-called metal plate/foil. In addition, from a viewpoint of corrosion resistance, the metal layer 17 may be a metal-plated material like a Galvalume steel plate.

With the metal layer 17 having an excessively thin thickness, the solar cell module 10 having weak mechanical strength will be obtained. Moreover, with the metal layer 17 having an excessively thick thickness, the solar cell module 10 having a heavy weight will be obtained. Therefore, depending on the constitute material (strength of the constitute material) of the metal layer 17, it is preferred that the thickness of the metal layer 17 be not more than 10 mm, preferably be not more than 5 mm, and particularly preferably be not more than 3 mm. Moreover, it is preferred that the thickness of the metal layer 17 be not less than 0.1 µm, more preferably be not less than 0.08 mm, particularly preferably be not less than 0.1 mm.

### [Power Generation Element 13]

The power generation element 13 is an element that generates electricity on the basis of the sunlight entered from the direction of the weather resistant layer 11. The power generation element 13 may be any element as long as it can convert light energy into electrical energy, and has a structure that permits extraction of the electrical energy generated therein by the conversion.

It is therefore possible to use, as the power generation element 13 of the solar cell module 10, an element consisting of a power generation layer (a photoelectric conversion layer, a photoabsorption layer) sandwiched between a couple of electrodes; an element consisting of a stack of a power generation layer and another layer(s) (a buffer layer etc.) sandwiched between a couple of electrodes; an element consisting of such elements wired up in serial and/or parallel with one another; or the like. Moreover, there are various layers that can be used as the power generation layer of the power generation element 13. However, it is preferred that the power generation layer be a layer consisting of thin film single crystal silicon, thin film polycrystalline silicon, spherical silicon, amorphous silicon, microcrystalline silicon, inorganic semiconductor material, organic dye material, organic semiconductor material, or the like. The reason is that, by using these materials, it is possible to obtain the power generation element 13 of which a power generation efficiency is relatively high and which has a thin thickness (a light weight). Furthermore, in order to raise a power-generation performance, it is possible to configure the power generation element 13 as a HIT type element which is a stack of above-mentioned layers, and a tandem type element.

Note that, the power generation element 13 having a thin film polycrystalline silicon layer as the power generation layer serves as a element that utilizes indirect photon transition. Therefore, when a thin film polycrystalline silicon layer is adopted as the power generation layer, it is desirable, in order to enhance photoabsorption, to introduce a light trapping structure by fabricating relief structures on the power generation element substrate 14 or the surface of the power generation layer.

Moreover, by using an amorphous silicon layer as the power generation layer, the power generation element 13 with a large optical absorption coefficient in the visible region, which can fully absorb the sunlight even if its thickness is about 1 µm, can be actualized. Besides, since amorphous silicon, micro crystallite silicon, inorganic semiconductor materials, organic dye materials, and organic-semiconductor materials are noncrystalline materials or low crystalline materials, they have tolerance to the deformation. Consequently, by adopting the power generation element 13 including the amorphous silicon layer as the power generation layer, it is possible to actualize the solar cell module 10 which is especially lightweight, and also has a certain degree of tolerance to the deformation.

By using an inorganic semiconductor (compound semiconductor) layer as the power generation layer, the power generation element 13 with a high power generation efficiency can be actualized. Note that, from the viewpoint of the power generation efficiency (photoelectric conversion efficiency), it is preferred that the power generation layer be a chalcopyrite power generation layer containing a chalcogen element(s) such as S, Se, Te, etc., more preferably be I-III-VI2 group semiconductor (chalcopyrite) power generation layer, most preferably be a Cu-III-VI2 group semiconductor power generation layer containing Cu as the group I element, especially the CIS semiconductor [CuIn (Se_{1-y}S_{y}) ₂; 0 ≤ y ≤1] layer or the CIGS semiconductor [Cu (In₁-ₓGaₓ) (Se₁-_{y}S_{y}) ₂; 0 < x < 1, 0 ≤ y ≤ 1] layer.

It is also possible to actualize the power generation element 13 with a high power generation efficiency by using as the power generation layer a dye-sensitized power generation layer consisting of a titanium oxide layer, an electrolyte layer, etc.

It is also possible to adopt an inorganic semiconductor layer (a layer containing p-type semiconductor and n-type semiconductor) as the power generation layer. Note that, examples of a p-type semiconductor of the organic semiconductor layer are: porphyrin compounds such as tetrabenzoporphyrin, tetorabenzo copper porphyrin, tetorabenzo zinc porphyrin, etc.; phthalocyanine compounds such as phthalocyanine, copper phthalocyanine, zinc phthalocyanine, etc.; polyacenes such as tetracene, pentacene, etc.; oligothiophens such as sexithiophene; and derivatives containing these compounds as skeletons. Polymers such as polythiophene containing poly(3-alkylthiophene) or the like, polyfluorene, polyphenylene vinylene, poly triallyl amine, polyacetylene, polyaniline, polypyrrole, etc. are also examples of a p-type semiconductor layer of the organic semiconductor layer.

Examples of p-type semiconductor of the organic semiconductor layer are: fullerenes (C60, C70, and C76); octaazaporphyrin; perfluoro forms of the above-mentioned p-type semiconductors; aromatic carboxylic acid anhydrides such as naphthalenetetracarboxylic acid anhydride, naphthalenetetracarboxylic acid diimide, perylenetetracarboxylic acid anhydride, and perylenetetracarboxylic acid diimide; imide compounds of the aromatic carboxylic acid anhydrides; and derivatives containing these compounds as skeletons.

Examples of practical structure of the organic semiconductor layer are a bulk heterojunction type structure including a layer (i-layer) in which the p-type semiconductor and n-type semiconductor are phase-separated, a stacked type (hetero p-n junction type) structure in which a layer (p-layer) containing the p-type semiconductor and a layer (n-layer) containing the n-type semiconductor have an interface, a Schottky type structure, and combinations of these structures.

Each electrode of the power generation element 13 can be formed by using one or more arbitrary conductive materials. Examples of electrode material (constitute material of the electrode) are: metals such as platinum, gold, silver, aluminum, chromium, nickel, copper, titanium, magnesium, calcium, barium, and sodium, or alloys thereof; metal oxides such as indium oxide and tin oxide, or their compound (ITO (Indium Tin Oxide), etc.); conductive polymers such as polyaniline, polypyrrol, polythiophene, and polyacetylene; materials obtained by adding dopants, for example, acids such as hydrochloric acid, sulfuric acid, and sulfonic acid, Lewis acids such as FeCl₃, halogen atoms such as iodine, and metal atoms such as sodium and potassium, to the above-mentioned conductive polymers; and conductive composite materials obtained by dispersing conductive particles such as metal particles, carbon black, fullerene, and carbon nanotubes in a matrix such as a polymer binder.

It is preferred that the electrode material be a material suitable for collecting holes or electrons. Examples of the electrode material suitable for collecting holes (in other words, high work function materials) are Au, ITO, etc. Moreover, examples of the electrode material suitable for collecting electrons (in other words, low work function materials) are Silver, aluminum, etc.

Each electrode of the power generation element 13 may either be almost the same size as the power generation layer, or be smaller than the power generation layer. However, in a case where the electrode on the light receiving side (on the surface near the weather resistant layer 11) of the power generation element 13 is relatively large (is not smaller enough than the power generation layer), it should be an transparent (translucent) electrode, especially, an electrode whose optical transmittance over the wavelength range where the power generation layer can efficiently converts the sun's energy into electrical energy is relatively high (for example, not less than 50 %). In addition, examples of the transparent electrode material are oxides such as ITO, IZO (indium oxide-zinc oxide), etc.; metal thin films; and the like.

Moreover, although thicknesses of the electrode and the power generation layer of the power generation element 13 can be determined on the basis of the required output, etc.

Further, an auxiliary electrode can be arranged so that it contacts with the electrode. Arrangement of the auxiliary electrode is effective in a case where a relatively low conductance material, such as ITO, is used as electrode. As an auxiliary electrode material, any high conductive material in the above-mentioned metals can be used. Examples of the auxiliary electrode material are silver, aluminum, and copper.

### [Power Generation Element Substrate 14]

The power generation element substrate 14 is a member on a surface of which the power generation element 13 is formed. It is therefore desired that the power generation element substrate 14 have relatively high mechanical strength, be lightweight, and be excellent in weather resistance, heat resistance, water resistance, etc. The power generation element substrate 14 is also desired to have a certain degree of tolerance to deformation. However, in a case where physical properties (for example, coefficient of linear expansion, melting point, etc.) of the power generation element substrate 14 are markedly different from those of the power generation element 13, there is a possibility that distortion, exfoliation, etc. may occur in the interface between the power generation element substrate 14 and the power generation element 13 formed on the substrate 14.

It is therefore preferable to employ, as the power generation element substrate 14, a metal foil, a resin film whose melting point is 85-350 °C, or a stack of some foils and/or resin films.

Examples of the metal foil that can be used as the power generation element substrate 14 (or its component) are foils of aluminum, stainless steel, gold, silver, copper, titanium, nickel, iron, and alloys of these metals.

Examples of the resin film whose melting point is 85-350 °C are films of polyethylene; polypropylene; polystyrene; polyvinyl chloride; polyethylene terephthalate; polyethylenenaphthalate; polybutylene terephthalate; polycarbonate; polyacetal; acryl resin; polyamide resin; ABS resin; ACS resin; AES resin; ASA resin; copolymers of these resins; fluorocarbon resin such as PVDF, PVF, etc.; silicone resin; cellulose; nitrile resin; phenol resin; polyurethane; ionomer; polybutadiene; polybutylene; polymethylpenten, polyvinylalcohol; polyarylate; polyetheretherketone; polyetherketone; polyethersulfone; etc. Moreover, from the viewpoint of the productivity of the metal resin composite substrate 16, it is desirable that the resin film be made of thermoplastic resin. In addition, the resin film used as the power generation element substrate 14 may be a film made by dispersing inorganic substances such as antimony oxide, antimony hydroxide, barium borate, and glass fibers, organic fibers, carbon fibers, etc. into one of the above-mentioned resins.

The reason why the melting point of the resin film used as the power generation element substrate 14 (or its component) is preferred to be 85 °C or more is that, when the melting point is too low, there is a possibility that the power generation element substrate 14 may deform under the usual operating environment of the solar cell module 10, giving damage to the power generation element 13. The reason why the melting point of the resin film is preferred to be 350 °C or less is that, when the melting point is too high, there is a possibility that the interface between the power generation element 13 and the power generation element substrate 14 is distorted due to temperature change and the like, causing separation of the power generation element 13 from the power generation element substrate 14.

Hence, the melting point of the resin film used as the power generation element substrate 14 (or its component) is more preferably not lower than 100 °C, further preferably not lower than 120 °C, still further preferably not lower than 150 °C, and most preferably not lower than 180 °C. Also, the melting point of the resin film is more preferably not higher than 300 °C, even more preferably not higher than 280 °C, and particularly preferably not higher than 250 °C.

Moreover, various test results has been revealed that the solar cell module 10 having the power generation substrate 14 thinner than the encapsulation layer 12 (details will be described later) could often cause cracks in the encapsulation layer 12, etc. when being bent. Therefore, the thickness of the power generation substrate 14 is preferably thinner than the encapsulation layer 12, and more preferably 0.83 (= 1/1.2) times as thick as the encapsulation layer 12 or less. Moreover, the thickness of the power generation substrate 14 is still more preferably 0.67 (= 1/1.5) times as thick as the upper encapsulation layer 12 or less, and particularly preferably 0.5 times as thick as the encapsulation layer 12 or less.

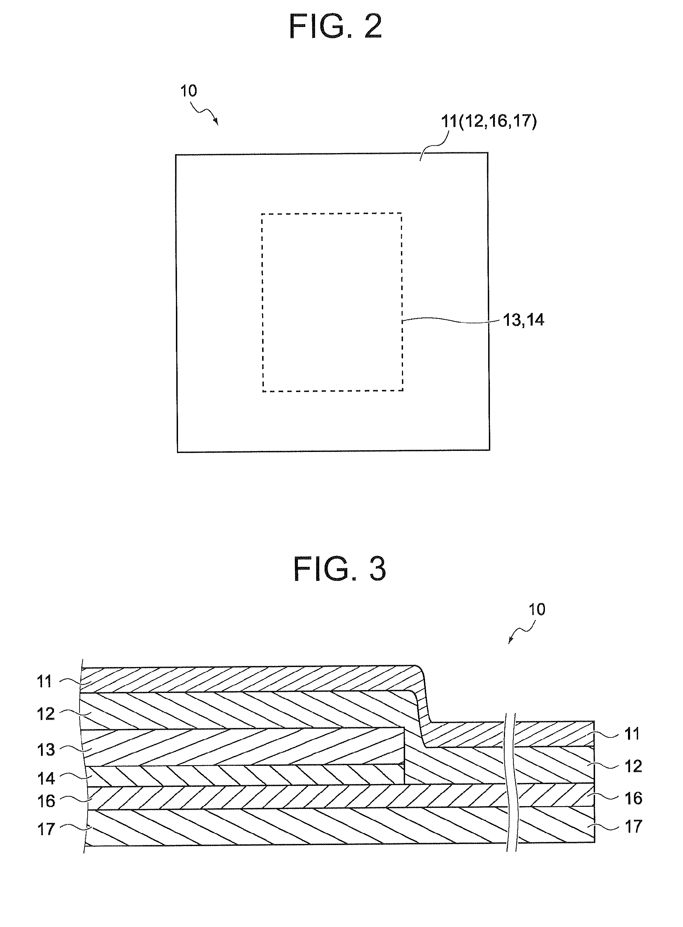

Note that the solar cell module of the present invention has been developed on the assumption that it is used as a building material for an exterior wall, an outer backpanel, a roof, etc., and a component (for example, an exterior material) of an automobile, interior design, a rail motor, a vessel, an airplane, a spacecraft, a home appliance, a portable cellular phone, and a toy. And, when being used for such purposes, it is better that the metal layer 17 is viewable from the viewpoint of an aesthetic appeal as the exterior material. Therefore, it is preferred that the solar cell module 10 is configured, as schematically shown in FIGS. 2 and 3, so that the power generation element substrate 14 and the power generation element 13 are definitely smaller than other components.

Although, in FIG. 2 and FIG. 3, the weather resistant layer 11, the encapsulation layer 12, the fluorinated hydrocarbon resin layer 16, and the metal layer 17 are shown in the almost same size, the weather resistant layer 11 and the encapsulation layer 12 are able to be smaller than the fluorinated hydrocarbon resin layer 16 and the metal layer 17 as long as they are larger than the power generation element substrate 14 and the power generation element 13. However, from the viewpoint of giving the metal layer 17 high weather resistance, it is preferred that the fluorinated carbonization resin layer 16 cover at least one side of the metal layer 17.

### [Fluorinated hydrocarbon resin layer 16]

The fluorinated hydrocarbon resin layer 16 is a layer for bonding the power generation element substrate 14 and the metal layer 17 together (bonding the power generation element substrate 14 to the metal layer 17). As obvious by its name, this fluorinated hydrocarbon resin layer 16 only needs being a layer of a "fluorinated hydrocarbon resin." Therefore, It is possible to adopt as the fluorinated hydrocarbon resin layer 16 a layer made of one of the following examples.
PFA (tetrafluoroetylene-perfluoroalkylvinylether copolymer)
ETFE (ethylene-tetrafluoroethylene copolymer)
PVDF (polyvinydene fluoride)
ECTFE (ethylene-chlorotrifluoroethylene copolymer)
FEVE (fluoroethylene-vinylether copolymer)
PTFE (polytetrafluoroethylene)
FEP (tetrafluoroethylene-hexafluoropropylene copolymer)
PCTFE (polychlorotrifluoroethylene)

However, a PTFE layer, a FEP layer, or a PCTFE layer as the fluorinated hydrocarbon resin layer 16 may need a surface treatment to obtain sufficient adhesion strength. It is therefore preferred that the constitute resin of the fluorinated hydrocarbon resin layer 16 be a PFA, an ETFE, a PVDF, an ECTFE, or an FEVE.

The fluorinated hydrocarbon resin layer 16 is more preferable be a copolymer such as a PFA, an ETFE, a PVDF, an ECTFE, an FEVE, or the like. The fluorinated hydrocarbon resin layer 16 is particularly preferable be an alternating copolymer. Note that, when adopting a copolymer (an alternating copolymer) of the above-mentioned resins as the fluorinated hydrocarbon resin layer 16, it is possible to obtain the fluorinated hydrocarbon resin layer 16 exhibiting high adhesion and weather resistance during exposure to sunlight by adjusting the balance of a polar monomer and a nonpolar monomer.

The thickness of the fluorinated hydrocarbon resin layer 16 is preferable not less than 1 µm, more preferably not less than 5 µm, and particularly preferably not less than 10 µm. Moreover, the thickness of the fluorinated hydrocarbon resin layer 16 is preferable not more than 500 µm, more preferable not more than 300 µm, and particularly preferable not more than 100 µm.

### [Encapsulation Layer 12]

The encapsulation layer 12 is a layer prepared in the solar cell module 10 for purposes of encapsulating the power generation element 13, etc.

The encapsulation layer 12 also contributes to the improvement in mechanical strength, weather resistance, gas barrier properties, etc. Moreover, since the encapsulation layer 12 is arranged at the light receiving surface side, it is preferred that the encapsulation layer 12 be a layer through which visible light permeates and which is highly resistant to heat. It is possible to give another optical function(s) or mechanical function(s) to the encapsulation layer 12. Examples of the optical function are a light trapping function, a wavelength conversion function, etc., and examples of the mechanical function are a cushion function, etc.

Material for the encapsulation layers 12 should be selected in consideration of the above-mentioned matters. Practical examples of the material for the encapsulation layer 12 are ethylene-vinyl acetate copolymer (EVA) resins, polyolefin resins, AS (acrylonitrile-styrene) resins, ABS (acrylonitrile-butadiene-styrene) resins, polyvinyl chloride resins, fluorocarbon resins, polyester resins exemplified by a polyethylene terephthalate, a polyethylene naphthalate, etc., phenol-formaldehyde resins, polyacrylate resins, polymethacrylate resins, chloroprene resins, (hydrogenated) epoxy resins, polyamide resins represented by various nylons, polyimide resins, polyamide-imide resins, polyurethane resins, cellulose resins, silicone resins, polycarbonate resins, etc.

Among these, preferable resins are the ethylene copolymers, and more preferable resins are the ethylene-vinyl acetate copolymer (EVA) resins or the polyolefin resins that consist of ethylene and other olefins such as propylene-ethylene-α-olefin copolymers, ethylene-α-olefin copolymers, etc.

When preparing an EVA resin, in order to enhance the resistance to weather, a crosslinking agent to bride polymer chains is blended into an ethylene-vinyl acetate copolymer (EVA) resin compound. As the crosslinking agent, usually, an organic peroxide which produces radicals above 100 °C is used. Examples of the organic peroxide are 2,5-dimethyl hexane, 2,5-dihydro peroxide, 2,5-dimethyl-2,5-di(tert-butylperoxy)hexane, 3-di-tert-butylperoxide, etc. The blending quantity of the organic peroxide is usually 1 to 5 parts per weight to 100 parts by weight of the EVA resin. Moreover, the EVA resin compound may contain a crosslinking coagent.

It is feasible to mix a silane coupling agent into EVA resin compound for the purpose of enhancing the adhesive strength, and/or to mix hydroquinone, etc., into the EVA resin compound for the purpose of enhancing stability.

As the propylene-ethylene-α-olefin copolymer, a thermoplastic resin compound that is a blend of a propylene polymer and a plasticized propylene polymer of suitable composition is usually used.

The encapsulation layer 12 can be made of a material to which a flame-retardant material is added. The flame-retardant material added into the encapsulation layer 12 may be an inorganic flame-retardant material, or an organic flame-retardant material. Examples of the inorganic flame-retardant material are metal oxides such as antimony compounds, bromine compounds, an aluminum hydroxide, a magnesium hydroxide, etc. Examples of the organic flame-retardant material are bromine compounds such as pentabromodihpenyl ether, octabromodiphenyl ether, tetrabromobisphenolA, hexabromocyclododecane, etc.; phosphorus compounds such as triphenyl phosphate, etc.; chlorinated compounds such as red phosphorus, chlorinated paraffin, etc. Since low transparency of the encapsulation layer 12 usually leads to degraded output of the solar cell, it is preferred that the flame-retardant material added into the encapsulation layer 12 be an inorganic flame-retardant material. Moreover, as to a film substrate solar cell element, there is a danger that organic flame-retardant materials damage the element. It is therefore preferred that the flame-retardant material, which is added to the encapsulation layer 12 for the film substrate solar cell element, be a bromine compound such as pentabromodihpenyl ether, octabromodiphenyl ether, tetrabromobisphenolA, hexabromocyclododecane, etc.; a phosphorus compound such as triphenyl phosphate, etc.; or the like.

The encapsulation layer 12 may be either a mixture of two or more of the above-mentioned materials or a stack of two or more different material layers.

Moreover, the solar cell module 10 has, as its component, the metal layer 17 of which a coefficient of linear expansion differs greatly from that of the weather resistant layer 11 (which will be detailed later). That is, the solar cell module 10 is a module in which a relatively large stress (distortion) may be generated due to the difference in the expansion quantity of the weather resistant layer 11 and the metal layer 17 when the module temperature changes. Hence, when the thickness of the encapsulation layer 12 is too thin to absorb the stress, the electrodes and/or the power generation layer of the power generation element 13 will be damaged. Moreover, use of the encapsulation layer 12 having a thin thickness results in the solar cell module that is easy to be damaged when it is processed into another shape (for example, when the solar cell module 10 is processed into a curved shape), and has low impact resistance.

Accordingly, from the above viewpoints, it is better that the encapsulation layer 12 is thicker. However, an increase of the thickness of the encapsulation layer 12 results in an increase of module weight and manufacturing cost. Therefore, it is preferred that the thickness of the encapsulation layer 12 be not less than 30 µm, more preferably not less than 120 µm, even more preferably not less than 150 µm, an particularly preferably not less than 300 µm. Moreover, it is preferred that the thickness of the encapsulation layer 12 be not more than 800 µm, more preferably not more than 700 µm, and particularly preferably not more than 600 µm.

Furthermore, as the encapsulation layer 12, a layer whose thickness is not less than 1 times, preferably not less than 1.2 times, more preferably not less than 1.5 times, even more preferably not less than 2 times the thickness of the power generation element substrate 14 is used. Because, as already mentioned, when the encapsulation layer 12 is thinner than the power generation element substrate 14, it follows that the solar cell module prone to cracks in the encapsulation layer 12 when being bent.

### [Weather Resistant Layer 11]

The weather resistant layer 11 is a layer for giving mechanical strength, weather resistance, scratch resistance, chemical resistance, gas barrier properties, etc. to the solar cell module 10. It is preferable that the weather resistant layer 11 be a layer that does not disturb the photoabsorption of the power generation element 13, namely, a layer though which light of wavelengths which the power generation layer can efficiently converts into electrical energy. The weather resistant layer 11 be a layer whose that does not disturb the photoabsorption of the power generation element 13, namely, a layer though which light of wavelengths which the power generation layer can efficiently converts into electrical energy. More concretely, It is preferred that the weather resistant layer 11 be a layer whose solar transmittance is not less than 80 %, and more preferably be a layer whose solar transmittance is not less than 85 %.

Moreover, since the solar cell module is heated by sunlight, it is desirable the weather resistant layer 11 have heat resistance. It is therefore preferable that the melting point of the constitute material of the weather resistant layer 11 be not less than 100 °C, and more preferably be not less than 120 °C.

Moreover, it is preferred that the melting point of the constitute material of the weather resistant layer 11 be not more than 320 °C, and more preferably be not more than 300 °C.

The constitute material of the weather resistant layer 11 can be selected taking the above-mentioned matters into consideration. Examples of the constitute material of the weather resistance layer 11 are polypropylene resins, cyclic polyolefin resins, AS (acrylonitrile styrene) resins, ABS (acrylonitrile-butadiene-styrene) resins, polyvinyl chloride resins, fluorocarbon resins such as PFA, FEP, PCTFE, ETFE, ECTFE, PVDF, and PVF, polyester resins such as polyethylene telephthalate and polyethylene naphthalate, polyester resins exemplified by polyethylene terephthalate, polyethylene naphthalate, etc., phenol-formaldehyde resins, polyacrylate resins, polymethacrylate resins, chloroprene resins, (hydrogenated) epoxy resins, polyamide resins represented by various nylons, polyimide resins, polyamide-imide resins, polyurethane resins, cellulose resins, silicone resins, polycarbonate resins, etc. Note that, when weather resistance is important, it is preferable to use a fluorocarbon resin such as ETFE, etc. as the constitute material of the weather resistant layer 11.

The weather resistant layer 11 may be either a mixture of two or more of the above-mentioned materials or a stack of two or more different material layers.

Although the thickness of the weather resistance layer 11 is not limited, a decrease of the thickness usually results in a decrease of the mechanical strength, and an increase of the thickness usually results in an increase of the flexibility. Therefore, the thickness of the whether resistant layer 11 is usually 10 µm or over, preferably 15 µm or over, and more preferably 20 µm or over. Furthermore, the thickness of the weather resistant layer 11 is usually 200 µm or less, preferably 180 µm or less, and more preferably 150 µm or less.

In short, as the weather resistant layer, a layer of any thickness, which is made of a material having whether resistance, heat resistance, etc.

However, various test results revealed that, when the filtered maximum waviness WCM of the surface of the weather resistant layer 11 is small (especially, smaller than 18 mm), the solar cell module which is **dazziling** when viewed from some angles is obtained because amount of incident light that is specular reflected at the surface of the weather resistant layer 11 is high. It was also found that, since stress due to heat shrinkage during its production cannot be reduced, many folds are formed on the surface of the weather resistant layer 11. It is therefore preferred that the filtered maximum waviness WCM in conformity with JIS B0610 of the surface of the weather resistant layer 11 be not less than 18 µm, more preferably be 18 µm, and particularly preferably be 25 µm.

It was found that, when a mean spacing of local peaks of waviness, WC-Sm, of the surface of the weather resistant layer 11 was excessively large, light reflected by the metal layer 17 (a part of the metal layer 17 not covered with the power generation element 13, etc.; refer to FIGS. 2 and 3) diffused on the surface of the weather resistant layer 11, and hence usually the gloss of the metal layer 17 was lost (the aesthetic appeal of the metal layer 17 was spoiled). Furthermore, it was found that, when unevenness of the surface of the weather resistant layer 11 was excessively large, the surface of the weather resistant layer 11 was prone to be strained, and therefore a power generation feature was prone to be degraded.

Therefore, when manufacturing the solar cell module 10, it is desired that the mean spacing of local peaks of waviness, WC-Sm, of the surface of the weather resistant layer 11 be not more than 2.5 mm, more preferably be not more than 2.3 mm, even more preferably not more than 2.0 mm.

A method of forming the above-mentioned profile is not particularly limited. For example, it is possible to use a layer originally having an uneven surface profile as the weather resistant layer 11, and it is possible to make the surface of the weather resistant layer 11 uneven by mechanical processing (scraping, etc.) the surface of the weather resistant layer 11. It is also possible to transfer profile of an uneven sheet to the surface of the weather resistant layer 11 by pressing the uneven sheet to the surface of the weather resistant layer 11. Moreover, it is possible to print a material on the surface of the weather resistant layer 11 so as to have an uneven profile.

It is desirable that the distance between the metal layer 17 and the power generation element substrate 14 be not less than 10 µm, more preferably be not less than 150 µm, and particularly preferably be not less than 300 µm. Moreover, it is desirable that the distance between the metal layer 17 and the power generation element substrate 14 is not more than 800 µm, and more preferably is not less than 700 µm. In order to insulate the power generation element 13 from the metal layer, distance between the metal layer 17 and the power generation element 13 is set not less than 10 µm. It is preferred that distance between the metal layer 17 and the power generation element 13 is enlarged in a case where the solar cell module is large, for example, larger than 1 m².

### [Manufacturing method of solar cell module 10]

Basically, the solar cell module 10 is a module that can be manufactured by unifying (uniting) components by thermal lamination (vacuum lamination). However, it is possible to manufacture the solar cell module 10 by procedures including a process/step of bonding components with an adhesive agent.

Note that, laminating temperature is preferable not less than 100 °C, more preferable not less than 110 °C, and particularly preferable not less than 120 °C. Moreover, laminating temperature is preferable not more than 180 °C, and more preferable not more than 170 °C.

It is possible to prepare every component separately, and then to manufacture the solar cell module 10 by thermal lamination. However, preparing the power generation element 13 and the power generation element substrate 14 separately results in the difficulty to manufacture the solar cell module 10. It is therefore desirable to form the power generation element 13 on the power generation element substrate 14 before unifying the components of the solar cell module 10 by thermal lamination.

Moreover, forming the fluorinated hydrocarbon resin layer 16 on the metal layer 17 before unifying the components of the solar cell module 10 allows the fluorinated hydrocarbon resin layer 16 to be formed by a process, for example, baking finish, by which a member consisting of the metal layer 17 and the fluorinated hydrocarbon resin layer 16 adhered firmly on the metal layer 17 can be fabricated easily. Accordingly, forming of the fluorinated hydrocarbon resin layer 16 on the metal layer 17 is desirably performed before unifying the components of the solar cell module 10 by thermal lamination.

Furthermore, if the above mentioned method of making the surface of the weather resistant layer 11 uneven by utilizing the uneven sheet is employed as a method of making the surface of weather resistant layer 11 uneven, it is feasible to make the surface of the weather resistant layer 11 uneven while the components of the solar cell module 10 are unified by thermal lamination. It is therefore desirable to employ a method by which the surface of the weather resistant layer 11 is made uneven by utilizing the uneven sheet while the components of the solar cell module 10 is unified by thermal lamination to manufacture the solar cell module 10.

### «Second Embodiment»

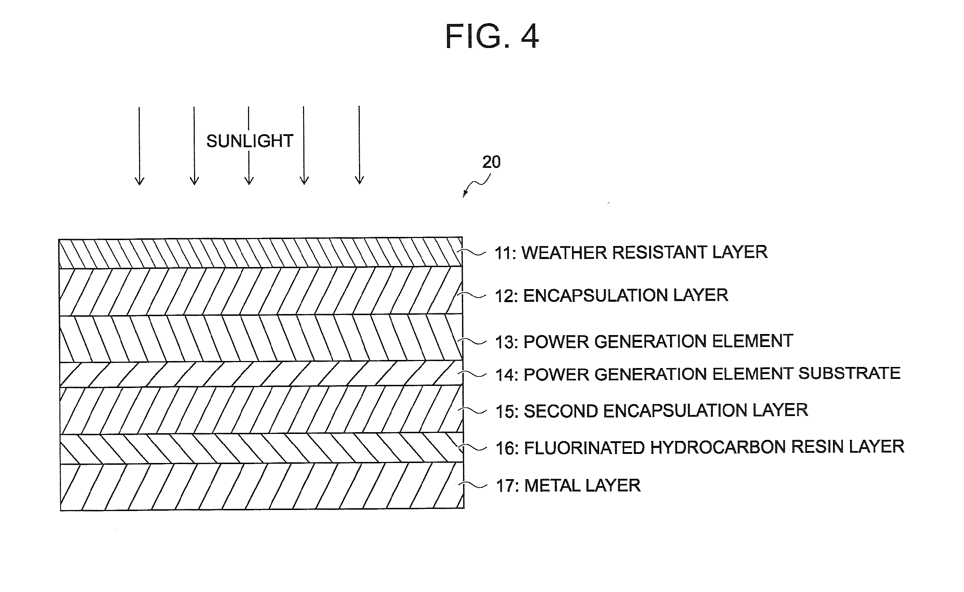

FIG. 4 is a sectional view of a principal part of a solar cell module according to a second embodiment of the present invention.

As obvious from a comparison between FIG. 4 and FIG. 1, the solar cell module 20 of the 2nd embodiment of the present invention is the modified version of the solar cell module 10 so as to include a second encapsulation layer between the power generation element substrate 14 and the fluorinated hydrocarbon resin layer 16.

The second encapsulation layer 15 is a layer prepared in the solar cell module 20 for purposes of encapsulating the power generation element 13, etc. Any material usable as a constitute material of the encapsulation layer 12 is also usable a constitute material of the second encapsulation layer 15. However, as is evident from its position, the second encapsulation layer can be a layer made of a non-transparent material.

The thickness of the second encapsulation layer 15 is not particularly limited. However, it is preferred that the thickness of the second encapsulation layer 15 be not less than 100 µm, more preferably be not less than 120 µm, still more preferably be not less than 150 µm, and particularly preferably be not less than 320 µm. Moreover, it is preferred that the thickness of the second encapsulation layer 15 be not more than 800 µm, more preferably be not more than 700 µm, and particularly preferably be not less than 600 µm. If the thickness of the second encapsulation layer 15 is within these ranges, it is possible to insulate the power generation element 13 from the metal layer 17.

With the structure of the solar cell module 20 of Example 2, as long as components other than the second encapsulation layer 15 are layers that meet above specifications, the solar cell module 20 that is practically usable and exhibits excellent durability.

The present invention will be hereinafter discussed in detail by way of its examples and comparative examples.

Note that, in the following discussion, the solar cell module of Example n/comparative example n (n = 1, 2, ...) connotes not one specific solar cell module, but the solar cell modules manufactured from the same materials and by the same procedures.

To begin with, configuration and manufacturing procedures of the solar cell module of Examples 1-6 and the comparative example 1 and 2, will be described.

### «Example 1»

The solar cell module of Example 1 was a module classified into the solar cell module of the second embodiment (FIG. 4). The solar cell module of Example 1 was manufactured by the following

First, a backside electrode, an amorphous silicon layer (power generation layer), and transparent electrode were formed on a 50-µm-thick PET film as the power generation element substrate 14 to fabricate the power generation element substrate 14 having the power generation element 13 on its surface. Note that "the power generation element substrate 14 having the power generation element 13 on its surface" fabricated was a member that had dimensions of approximately 95 mm x 150 mm.

Moreover, an FEVE paint was coated on a 0.5-mm-thick aluminum plate as the metal layer 17 and was baked to obtain the metal layer 17 stacked with the fluorinated hydrocarbon resin layer 16. Note that baking (drying) temperature was 100 °C. Moreover, "the metal layer 17 stacked with the fluorinated hydrocarbon resin layer 16" fabricated was a member having dimensions of approximately 200 mm x 200 mm, namely, a member larger than "the power generation element substrate 14 having the power generation element 13 on its surface" (95 mm x 150 mm).

Next, the members fabricated, a 100-µm-thick ETFE film (100 HK-DCS available from AGC) as the weather resistant layer 11, a 300-µm-thick EVA film (F806 available from Hangzhou First PV Materials) as the encapsulation layer 12, a 300-µm-thick EVA film (the same as the above) as the second encapsulation layer 15 were stacked in the order (and direction) shown in FIG. 4, and thereafter a first glass cloth for transferring unevenness were placed on the weather resistant layer 11 (the ETFE film). Subsequently, the stack on which the 1st glass cloth was placed was subjected to thermal lamination (vacuum 5 min, applying pressure 5 min, holding 10 min) at 150 °C, and the 1st glass cloth was removed, thereby the solar cell module of Example 1 was obtained.

Note that, although an explanation of layout, etc. of extraction electrodes is omitted, the solar cell module of Example 1 (and each solar cell module which will be mentioned later) was manufactured using lead wires (Cu-O-100-4-R) available by Sanko Metal Industries as extraction electrodes.

### «Example 2»

The solar cell module of Example 2 was a module that differed from Example 1 only in the point that an adhesive agent layer was arranged (inserted) between the second encapsulation layer 15 and the fluorinated hydrocarbon resin layer 15.

More specifically, each component (the weather resistant layer 11, the encapsulation layer 12) of the solar cell module of Example 2 was the same as corresponding component of the solar cell module of the embodiment 1. Moreover, when manufacturing the solar cell module of Example 2, as with the solar cell module of Example 1, the 1st glass cloth was placed on the whether resistant layer 11-side surface of the stack of the module's components, and the stack with the 1st glass cloth was subjected to thermal lamination (laminating temperature 150 °C, vacuum 5 min, applying pressure 5 min, holding 10 min).

However, the solar cell module of Example 2 was manufactured not by simply stacking "the metal layer 17 stacked with the fluorinated hydrocarbon resin layer 16" and other components, and then performing thermal lamination to the stack, but by coating "the metal layer 17 stacked with the fluorinated hydrocarbon resin layer 16" with an adhesive agent (in this Example; Aquatex AC-3100, which is an adhesive agent, manufactured by Chuo Rika Kogyo Co, Ltd.), stacking "the metal layer 17 stacked with the fluorinated hydrocarbon resin layer 16" coated with the adhesion agent and other components, and then performing thermal lamination to the stack.

### «Example 3»

The solar cell module of Example 3 was a module that differed from the solar cell module of Example 1 only in the point that a second glass cloth coarser than the first glass cloth was used in its manufacturing process (thermal lamination process). Namely, the solar cell module of Example 3 was so manufactured that unevenness of the surface of the weather resistant layer 11 could be larger than that of the solar cell module of Example 1.

### «Example 4»

The solar cell module of Example 4 was a module that differed from the solar cell module of Example 1 only in the point that any glass cloth was not used in its manufacturing process (the stack of its components was subjected to thermal lamination without placing a glass cloth on the stack). That is, the solar cell module of Example 3 was manufactured so that unevenness of the surface of the weather resistant layer 11 could be smaller than that of the solar cell module of Example 1.

### «Example 5»

The solar cell module of Example 5 was a module that differed from the solar cell module of Example 1 only in the point that conditions of thermal lamination was different from those for the solar cell module of Example 1. Concretely, the solar cell module of Example 5 was manufactured by thermal lamination in conditions of 145 °C, vacuum 5 min, applying pressure 5 min, and holding 25 min.

### «Example 6»

The solar cell module of Example 6 was a module that differed from the solar cell module of Example 1 only in the point that not a 0.5-mm-thick aluminum plate, but a 1-mm-thick coated steel panel was used.

### «Comparative Example 1»

The solar cell module of Comparative Example 1 was a module that was manufactured by the fundamentally same method as the solar cell module of Example 1. However, the solar cell module of Comparative Example 1 was a module that included a 0.5-mm-thick aluminum plate instead of "the metal layer 17 stacked with the fluorinated hydrocarbon resin layer 16" (a module which did not include the fluorinated hydrocarbon resin layer 16 and of which the metal layer 17 and power generation element substrate 14 were bonded by the 2nd encapsulation layer).

### «Comparative Example 2»

The solar cell module of Comparative Example 1 was also a module that was manufactured by the fundamentally same method as the solar cell module of Example 1. However, the solar cell module of Comparative Example 2 was a module that included "a 0.5-mm-thick aluminum plate on which polyester resin layer was formed" instead of "the metal layer 17 stacked with the fluorinated hydrocarbon resin layer 16" (a module including a layer made of a resin other than the fluorinated hydrocarbon resin in place of the fluorinated hydrocarbon resin layer 16).

Hereinafter, results of various evaluations of the above-mentioned solar cell module will be described.

### [Evaluation of power generation performance]

Evaluation of power generation performance of each solar cell module was performed by measuring maximum output of each solar cell module with a solar simulator (manufactured by Nisshinbo). As a result, it was found that maximum output of every solar cell module was approximately 0.53 W, namely, every solar cell module was the module that exhibited good power generation performance.

### [Evaluation of adhesiveness]

Evaluation of adhesiveness between the metal layer 17 and power generation substrate 14 of each manufactured solar cell module (each of the solar cell modules of examples and comparative examples), was performed by means of 180 degree peel test in conformity with JIS K6854-2 with a tension testing machine (STA-1150 manufactured by Oriented Co., Ltd.). More specifically, peel test samples in conformity with JIS K 6854-2 were made from respective manufactured solar cell modules, and adhesiveness between the metal layer 17 and power generation substrate 14 of each manufactured solar cell module was evaluated by performing 180 degree peel test to each peel test sample.

The measurement results revealed that, as listed in Table 1 below, whereas each of the solar cell modules (Example 1-4) including the fluorinated hydrocarbon resin layer 16 was the module in which the power generation element substrate 14 firmly adhered to the metal layer 17, the solar cell module (Comparative Example 1) in which the second encapsulating layer was arranged directly on the metal layer 17 showed an extremely low adhesive strength between the metal layer 17 and the power generation element substrate 14. Moreover, it was found that the solar cell module (Comparative Example 2) in which not the fluorinated hydrocarbon resin layer 16 but the polyester resin layer was arranged on the metal layer 17, showed the adhesive strength being not so high. Furthermore, it is confirmed that, by coating the adhesive agent on the fluorinated hydrocarbon resin layer 16 (Example 2), the power generation element substrate 14 can adhered to the metal layer 17 so firmly that a fracture ("BREAKDOWN") occurred at the spot not between the metal layer 17 and the power generation element substrate 14.

**Table 1**

| | ADHESIVE STRENGTH (N/25mm) |
|---|---|
| EXAMPLE 1 | 50 |
| EXAMPLE 2 | BREAKDOWN |
| EXAMPLE 3 | 47 |
| EXAMPLE 4 | 53 |
| COMPARATIVE EXAMPLE 1 | 10 |
| COMPARATIVE EXAMPLE 2 | 37 |

Consequently, it can be said that the layered structure that the metal layer 17, the fluorinated hydrocarbon resin layer 16, the second encapsulation layer 14, the power generation element 12, and the weather resistant layer 11 are stacked in this order a structure capable of realizing the solar cell module having high adhesive strength between the power generation element 13 is well insulated from the metal layer 17.

### [Evaluation of Surface Shape]

In order to clarify the relationship between the Surface Shape and the outside appearance of the solar cell module, a filtered maximum waviness (WCM), a mean spacing of local peaks (WC-Sm), a center line average roughness (Ra), a root mean square roughness (RMS), and a mean spacing of the profile irregularities (Sm) of each surface of the solar cell modules of Examples 1, 3 and 4 were measured with a surface roughness measuring machine (Surfcom 570A manufactured by Tokyo Seimitsu Co., Ltd.), and the outside appearance of each surface was visually inspected.

Measurement results of filtered maximum waviness, etc. of each of the solar cell modules of Example 1-4 are shown in Table 2.

**Table 2**

| | WCM (µm) | WC-Sm (µm) | Ra (µm) | RMS (µm) | Sm (µm) |
|---|---|---|---|---|---|
| EXAMPLE 1 | 32.8 | 1.86 | 2.53 | 3.20 | 0.31 |
| EXAMPLE3 | 47.4 | 2.55 | 5.47 | 6.47 | 0.90 |
| EXAMPLE 4 | 15.2 | 1.74 | 2.23 | 2.90 | 0.13 |

Moreover, from the visual inspection of the outside appearance of each solar cell module, it is found that the solar cell module of Example 4 was a module that had the surface with a little creases, and the solar cell modules of Examples 1 and 3 were modules which had no crease on their surface, and was not **dazziling,** and of which the part of the metal layer 17 not covered with the power generation element 13 and the power generation element substrate 14 had aesthetic metallic luster.

Furthermore, the filtered maximum waviness (WCM), etc. of each of the solar cell modules of Examples were the values shown in Table 2. Consequently, by manufacturing the solar cell module so that the surface of the weather resistant layer 11 has a filtered maximum waviness (WCM) in conformity with JIS B0601 of not less than 18 µm, and a mean spacing of local peaks (WC-Sm) of not more than 2.5 mm, the solar cell module having an especially excellent outside appearance can be obtained.

### [Evaluation of Durability]

The solar cell module of Example 1 was subjected to a high temperature/humidity test: 100 hours at 85 °C and 50 %RH, and a high temperature/humidity test: 200 hours at 85 °C and 85 %RH, and adhesive strength between the second encapsulation layer 15 and the fluorinated hydrocarbon resin layer 16 of the solar cell modules before/after the test. Moreover, the solar cell module of Example 6 was subjected to a high temperature/humidity test: 200 hours at 85 °C and 85 %RH, and adhesive strength between the second encapsulation layer 15 and the fluorinated hydrocarbon resin layer 16 of the solar cell modules before/after the test.

Measurement results of adhesive strength of the solar cell module of Example 1 are shown in Table 3, and measurement results of adhesive strength of the solar cell module of Example 6 is shown in Table 4. Incidentally, the reason why the initial value ("46") of adhesive strength in Table 3 is different from the initial value ("50") of adhesive strength in Table 3 is that there is a difference among individual solar cell modules that were manufactured by the same procedures, and moreover there is a slight difference in adhesive strength of a single solar cell module by position.

**Table 3**

| | ADHESIVE STRENGTH N/25mm | | |
|---|---|---|---|
| | INITIAL VALUE | 85 °C, 50 %, 100 HOURS | 85 °C, 85 %, 200 HOURS |
| EXAMPLE 1 | 46 | 50 | 54 |

**Table 4**

| | ADHESIVE STRENGTH N/25 mm | |
|---|---|---|
| | INITIAL VALUE | 85 °C, 85 %, 200 HOURS |
| EXAMPLE 2 | 82 | 76 |

Thus, the solar cell module including the fluorinated hydrocarbon resin layer 16 was the module of which adhesive strength between the second encapsulating layer 15 and the fluorinated hydrocarbon resin layer 16 was kept (not changed largely) even if it was held under high temperature and humidity environment for a long time. It can be therefore said that the layered structure of the metal layer 17, the fluorinated hydrocarbon resin layer 16,... , and the weather resistant layer 11 is a structure capable of realizing the solar cell module which has excellent durability (adhesive strength between the metal layer 17 and the power generation element substrate 14 of which is not degraded due to the long-term use).

### [Evaluation of Resistance to Humidity Freeze]

In order to evaluate resistance to humidity freeze, the solar cell performance of the solar cell module of Example 5 was evaluated (I-V characteristics of the solar cell module of Example 5 were measured), thereafter, the solar cell module of Example 5 was bent into a curved shape with a radius of 3,000 mm, and the solar cell performance of the bent solar cell module was evaluated. Moreover, the bent solar cell module was subjected to a humidity freeze test for 35 cycles from 85 °C, 85 %RH to -20 °C at 6 hours per cycle, and the solar cell performance of the solar cell module after the humidity freeze test was evaluated.

As a result, it is found that bending of the solar cell module did not cause degradation of solar cell performance, and the humidity freeze test, as shown in Table 5 below, did not cause large degradation of solar cell performance.

**Table 5**

| | 0 CYCLE | 35 CYCLES |
|---|---|---|
| OCV (V) | 34.07 | 33.87 |
| SCC (A) | 1.97 | 1.98 |
| MAXIMUM OUTPUT (W) | 42.65 | 42.91 |
| FILL FACTOR | 0.64 | 0.64 |

Consequently, it can be said that the layered structure of the metal layer 17, the fluorinated hydrocarbon resin layer 16, ... , and the weather resistant layer 11 is a structure capable of realizing the solar cell module having high resistance to bending and humidity freeze.

As for each of the solar cell modules of Examples, after applying 3000 V dc across the lead wire and the metal layer 17 (0.5-mm-thick aluminum plate, etc.) for one minute, leakage current was also measured.

From the measurement results, it was confirmed that leakage current of every solar cell module was not more than 50 µA. Consequently, it can be said that the layered structure of the metal layer 17, the fluorinated hydrocarbon resin layer 16, ... , and the weather resistant layer 11 is a structure capable of realizing the solar cell module in which the power generation element 13 is well insulated from the metal layer 17 (a short circuit between the power generation element 13 and the metal layer 17 rarely occurs).

### Industrial Applicability

According to the present invention, the solar cell module that is able to be used as a building material for an exterior wall, an outer backpanel, a roof, etc., and a component of an automobile, interior design, a rail motor, a vessel, an airplane, a spacecraft, a home appliance, a portable cellular phone, and a toy, can be obtained. Moreover, According to the manufacturing method of manufacturing a solar cell module of the present invention, the solar cell that can be used for various purposes can be manufactured easily.

### DESCRIPTION OF THE REFERENCE NUMERALS

- 10, 20:: solar cell module
- 11:: weather resistant layer
- 12:: encapsulation layer
- 13:: power generation element
- 14:: power generation element substrate
- 15:: second encapsulation layer
- 16:: fluorinated hydrocarbon resin layer
- 17:: metal layer

## Claims

1. A solar cell module, comprising:
a weather resistant layer, an encapsulation layer, a power generation element including a power generation layer sandwiched between a couple of electrodes, a power generation element substrate, a fluorinated hydrocarbon resin layer, and a metal layer stacked in this order.

2. The solar cell module according to claim 1, wherein the thickness of the encapsulation layer is not less than 30 µm and not more than 800 µm.

3. The solar cell module according to claim 1 or 2, wherein the thickness of the power generation element layer is thinner than the thickness of the encapsulation layer.

4. The solar cell module according to any one of claims 1 through 3, wherein the surface of the weather resistant layer has a filtered maximum waviness, WCM, in conformity with JIS B0601 of not less than 18 µm, and a mean spacing of local peaks, WC-Sm, of not more than 2.5 mm.

5. The solar cell module according to any one of claims 1 through 4, further comprising a second encapsulation layer arranged between the power generation element and the fluorinated hydrocarbon resin layer.

6. The solar cell module according to any one of claims 1 through 5, wherein the fluorinated hydrocarbon resin layer is made of a resin selected from the group consisting of tetrafluoroetylene-perfluoroalkylvinylether copolymer (PFA), ethylene-tetrafluoroethylene copolymer (ETFE), polyvinydene fluoride (PVDF), ethylene-chlorotrifluoroethylene copolymer (ECTFE), and fluoroethylene-vinylether copolymer (FEVE).

7. A method of manufacturing a solar cell module including a weather resistant layer, an encapsulation layer, a power generation element including a power generation layer sandwiched between a couple of electrodes, a power generation element substrate, a fluorinated hydrocarbon resin layer, and a metal layer stacked in this order, the method including:
unifying components of the solar cell module by thermal lamination.

8. The method according to claim 7, wherein the thickness of the encapsulation layer is 30 µm or more and 800 µm or less.

9. The method according to claim 7 or 8, wherein the thickness of the power generation element layer is thinner than the thickness of the encapsulation layer.

10. The method according to any one of claims 7 through 9, wherein said unifying unifies the metal layer on a surface of which the fluorinated hydrocarbon resin is formed, and other components of the solar cell module by thermal lamination.

11. The method according to any one of claims 7 through 9, wherein said unifying unifies the metal layer on a surface of which the fluorinated hydrocarbon resin is formed, the power generation element substrate on a surface of which the power generation element is formed, and other components of the solar cell module by thermal lamination.

12. The method according to any one of claims 7 through 11, wherein said unifying processes the surface of the weather resistant layer so as to have a filtered maximum waviness, WCM, in conformity with JIS B0601 of not less than 18 µm and a mean spacing of local peaks, WC-Sm, of not more than 2.5 mm.

13. The method according to any one of claims 7 through 12, by which the solar cell module including a second encapsulation layer arranged between the power generation element and the fluorinated hydrocarbon resin layer is manufactured.
